# EUROPEAN PATENT APPLICATION

(11) **EP 3 723 114 A1**
(43) Date of publication of application: **14.10.2020**
(21) Application number: 18886040.7
(22) Date of filing: 06.12.2018
(51) Int. Cl.: H01L 21/205, C30B 29/38, H01L 21/338, H01L 29/778, H01L 29/812

(54) **COMPOUND SEMICONDUCTOR SUBSTRATE**

(30) Priority: 08.12.2017 JP 2017235743
(71) Applicant: Air Water Inc., Osaka-shi Osaka 542-0081 (JP)
(72) Inventor: OUCHI, Sumito, Matsumoto-shi Nagano 390-1701 (JP); SUZUKI, Hiroki, Matsumoto-shi Nagano 390-1701 (JP); NARUKAWA, Mitsuhisa, Matsumoto-shi Nagano 390-1701 (JP); KAWAMURA, Keisuke, Matsumoto-shi Nagano 390-1701 (JP)
(74) Representative: Hering, Hartmut
(86) International application number: PCT/JP2018/044849
(87) International publication number: WO 2019/111986

(57) **Abstract**

A compound semiconductor substrate in which the warpage can easily be controlled is provided.

The compound semiconductor substrate comprises a SiC (silicon carbide) layer, an AlN (aluminum nitride) buffer layer formed on the SiC layer, and a lower composite layer formed on the AlN buffer layer, and an upper composite layer formed on the lower composite layer. The lower composite layer includes a plurality of lower Al (aluminum) nitride semiconductor layers vertically stacked and a lower GaN (gallium nitride) layer formed between the plurality of lower Al nitride semiconductor layers. The upper composite layer includes a plurality of upper GaN layers stacked vertically and an Al nitride semiconductor layer formed between the plurality of upper GaN layers.

## Description

### TECHNOLOGICAL FIELD

The present invention relates to a compound semiconductor substrate. More specifically, it relates to a compound semiconductor substrate capable of easily controlling warpage.

### DESCRIPTION OF THE RELATED ART

GaN (gallium nitride) has a larger band gap than Si (silicon), and GaN is known as a wide band gap semiconductor material having a high insulation breakdown field strength. Since GaN has higher dielectric breakdown resistance than other wide band gap semiconductor materials, it is expected to be applied to next-generation low-loss power devices.

When a Si substrate is used as the starting substrate (foundation substrate) of a semiconductor device using GaN, due to the large difference in the lattice constant value and thermal expansion coefficient between GaN and Si, the phenomenon in that warpage is generated on the substrate and cracks are generated in the GaN layer is likely to occur. For this reason, techniques for relaxing differences of the lattice constant values and thermal expansion coefficients between GaN and Si by a SiC layer or the like have been proposed, by using a compound semiconductor substrate with a SiC (silicon carbide) layer formed on the Si substrate as the starting substrate.

As such a technique, Patent Document 1 below and so on discloses a technique for suppressing the generation of substrate warpage and cracks. Patent Document 1 below discloses a compound semiconductor substrate comprising a SiC layer, an AlN (aluminum nitride) buffer layer formed on the SiC layer, a nitride semiconductor layer containing Al (aluminum) formed on the AlN buffer layer, a first GaN layer formed on the nitride semiconductor layer, a first AlN intermediate layer formed on the first GaN layer, which is in contact with the first GaN layer, and a second GaN layer formed on the first AlN intermediate layer, which is in contact with the first AlN intermediate layer.

### Prior Art Document

### Document(s) related to patents

[Patent Document 1] International publication No. 2017/069087

### SUMMARY OF THE INVENTION

### [Problems to be resolved by the invention]

When a thin film is epitaxially grown on the surface of the substrate under appropriate conditions, the thin film grows so as to be aligned with the crystal surface of the surface of the substrate. When the surface of the substrate and the thin film are different substances, tensile stress or compressive stress occurs in the thin film due to the difference in the lattice constant value between the surface of the substrate and the thin film. That is, when the lattice constant value of the thin film is smaller than the lattice constant value of the substrate surface, tensile stress occurs in the thin film. When the lattice constant value of the thin film is larger than the lattice constant value of the substrate surface, compression stress occurs in the thin film. In the state where tensile stress is generated in the thin film, a warpage that makes a concave shape occurs on the substrate. When compression stress is generated in the thin film, a warpage that makes a convex shape occurs on the substrate. Whether the warpage direction is a concave shape type or a convex shape type, cracks easily occur in the thin film, when the warpage amount of the substrate becomes large.

As described above, whether the direction of the substrate warpage after the thin film formation has a concave shape or a convex shape depends on types of the thin film (the size of the lattice constant value). With this in mind, it should be possible to reduce the warpage amount of the substrate after forming the thin film by adopting a convex shape substrate, if it is known in advance that the direction of the substrate warpage after the thin film formation will be a concave shape, and by adopting a concave shape substrate, if it is known in advance that the direction of the substrate warpage after the thin film formation will be a convex shape.

However, according to the conventional technology such as Patent Document 1, it is difficult to control the warpage of the substrate, and the amount of warpage after forming a thin film could not be reduced by the above method.

As a matter of course, the problem in that it is difficult to control the warpage of the substrate is not limited to the case where the thin film to be formed is made of GaN, and this is a problem that can occur when forming all kinds of thin films.

The present invention is to solve the above problems, the purpose is to provide a compound semiconductor substrate in which the warpage can easily be controlled.

### SUMMARY OF THE INVENTION

A compound semiconductor substrate in accordance with one aspect of the present invention comprises a foundation layer, a buffer layer made of AlN formed on the foundation layer, a lower composite layer formed on the buffer layer, and an upper composite layer formed on the lower composite layer, wherein the lower composite layer includes a plurality of lower nitride semiconductor layers containing Al stacked vertically, and a lower GaN layer formed between the plurality of lower nitride semiconductor layers, and the upper composite layer includes a plurality of upper GaN layers stacked vertically, and an upper nitride semiconductor layer including Al formed between the plurality of upper GaN layers.

Preferably, the foundation layer is made of SiC in the compound semiconductor substrate.

Preferably, the lower GaN layer has a thickness of 3 nanometers or more and 100 nanometers or less in the compound semiconductor substrate.

Preferably, the upper nitride semiconductor layer has a thickness of 3 nanometers or more and 50 nanometers or less in the compound semiconductor substrate.

Preferably, the plurality of lower nitride semiconductor layers are three layers, and the lower GaN layer has two layers in the compound semiconductor substrate.

Preferably, the plurality of lower nitride semiconductor layers include Al and Ga (gallium), and the lower nitride semiconductor layer formed at a position farther from the foundation layer has smaller average composition ratio of Al, when comparing the average composition ratio of Al of each of the plurality of lower nitride semiconductor layers in the compound semiconductor substrate.

Preferably, the plurality of upper GaN layers are three layers, and the upper nitride semiconductor layer has two layers in the compound semiconductor substrate.

Preferably, a lower nitride semiconductor layer formed on the lower GaN layer and in contact with the lower GaN layer among the plurality of lower nitride semiconductor layers includes tensile strain, and an upper GaN layer formed on the upper nitride semiconductor layer and in contact with the upper nitride semiconductor layer among the plurality of upper GaN layers includes compressive strain in the compound semiconductor substrate.

Preferably, the upper nitride semiconductor layer is made of AlN in the compound semiconductor substrate.

Preferably, an electron traveling layer made of GaN formed on the upper composite layer, and a barrier layer formed on the electrons traveling layer are further equipped in the compound semiconductor substrate.

Preferably, each of the plurality of upper GaN layers has an average carbon atom concentration of 1 ^{∗} 10¹⁸ atoms / cm³ or more and 1 ^{∗} 10²¹ atoms / cm³ or less in the compound semiconductor substrate.

Preferably, each of the plurality of upper GaN layers has a thickness of 550 nanometers or more and 3000 nanometers or less in the compound semiconductor substrate.

### EFFECT OF THE INVENTION

According to the present invention, a compound semiconductor substrate in which the warpage can easily be controlled can be provided.

### BRIEF DESCRIPTION OF THE DRAWINGS

FIG. 1 is a cross-sectional view showing the configuration of compound semiconductor substrate CS1 in the first embodiment of the present invention.
FIG. 2 is a diagram showing distribution of Al composition ratios inside composite layer 4 in the first embodiment of the present invention.
FIG. 3 is a cross-sectional view showing the structure of the compound semiconductor substrate CS2 in the second embodiment of the present invention.
FIG. 4 is a diagram showing measurement results of the warpage amount of each of samples A1, A2, and A3, according to one embodiment of present invention.
FIG. 5 shows a graph indicating the relationship between the thickness of the GaN layer 42b and the warpage amount obtained from the measurement results of the warpage amount of each of samples A1, A2, and A3, according to one embodiment of the present invention.
FIG. 6 is a diagram showing measurement results of the warpage amount of each of samples B1, B2, and B3, according to one embodiment of the present invention.
FIG. 7 is showing a graph indicating the relationship between the thicknesses of Al nitride semiconductor layers 52a and 52b and the warpage amount obtained from the measurement results of the warpage amount of each of samples B1, B2, and B3, according to one embodiment of the present invention.

### DETAILED DESCRIPTION OF EMBODIMENTS

Hereinafter, embodiments of the present invention will be described with reference to the drawings.

### [First Embodiment]

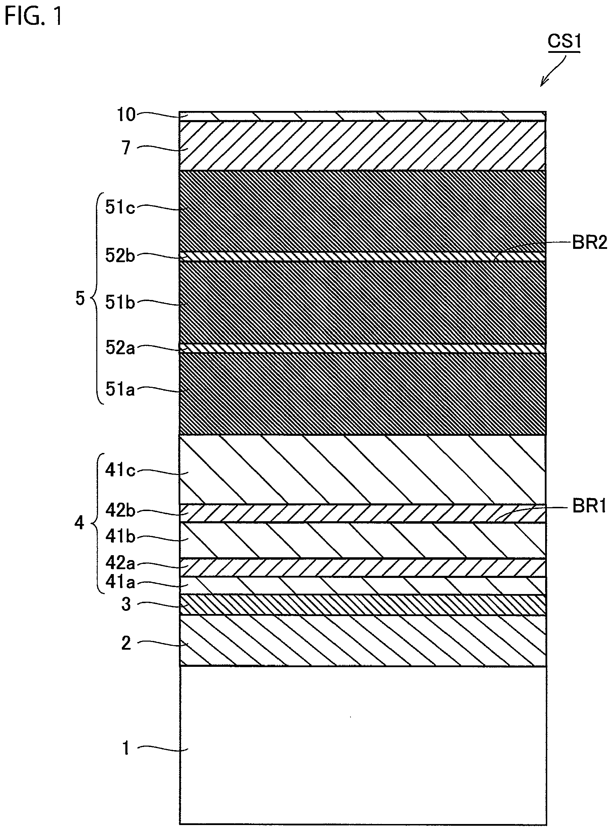

FIG. 1 is a cross-sectional view showing the structure of compound semiconductor substrate CS1 in the first embodiment of the present invention.

Referring to FIG. 1, compound semiconductor substrate CS1 in the present embodiment includes a HEMT (High Electron Mobility Transistor). Compound semiconductor substrate CS1 comprises Si substrate 1, SiC layer 2 (an example of a foundation layer), AlN buffer layer 3 (an example of a buffer layer), composite layer 4 (an example of a lower composite layer), composite layer 5 (an example of an upper composite layer), GaN layer 7 (an example of an electrons traveling layer), and Al nitride semiconductor layer 10 (an example of a barrier layer).

The Si substrate 1 is made of, for example, p+ type Si. The (111) plane is exposed on the surface of Si substrate 1. The Si substrate 1 may have an n-type conductivity or may be semi-insulating. The (100) plane or the (110) plane may be exposed on the surface of the Si substrate 1. The Si substrate 1 has a diameter of 6 inches, for example, and has a thickness of 1000 micrometers.

SiC layer 2 is in contact with Si substrate 1 and is formed on the Si substrate 1. SiC layer 2 is made of 3C-SiC, 4H-SiC, 6H-SiC, or the like. In particular, when SiC layer 2 was epitaxially grown on Si substrate 1, SiC layer 2 typically consists of 3C-SiC.

SiC layer 2 may be formed by homoepitaxial growth of SiC on the foundation layer made of SiC obtained by carbonizing the surface of Si substrate 1, using MBE (Molecular Beam Epitaxy) method, CVD (Chemical Vapor Deposition) method, LPE (Liquid Phase Epitaxy) method, or the like. The SiC layer 2 may be formed only by carbonizing the surface of the Si substrate 1. Further, the SiC layer 2 may be formed by heteroepitaxial growth on the surface of the Si substrate 1 (or with a buffer layer interposed therebetween). The SiC layer 2 is doped with N (nitrogen), for example, and has an n-type conductivity. The SiC layer 2 has a thickness of, for example, 0.1 micrometers or more and 3.5 micrometers or less. The SiC layer 2 may have p-type conductivity or may be semi-insulating.

Note that a layer made of any material can be used as the foundation layer of AlN buffer layer 3. As an example, the AlN buffer layer 3 may be directly formed on the Si substrate 1 without forming the SiC layer 2 on the Si substrate 1. In this case, the foundation layer for AlN buffer layer 3 is Si substrate 1. However, by forming SiC layer 2 between Si substrate 1 and AlN buffer layer 3, meltback etching (a phenomenon in which Ga in GaN layer7 diffuses and reacts with Si in Si substrate 1 to destroy Si substrate 1) can be surely suppressed by SiC layer 2.

AlN buffer layer 3 is in contact with SiC layer 2 and formed on SiC layer 2. AlN buffer layer 3 functions as a buffer layer that relaxes the difference in the lattice constant values between SiC layer 2 and the Al nitride semiconductor layer that composes composite layer 4. The AlN buffer layer 3 is formed by using, for example, the MOCVD (Metal Organic Chemical Vapor Deposition) method. The growth temperature of the AlN buffer layer 3 is, for example, 1000 degrees Celsius or more and less than the Si melting point. At this time, as the Al source gas, for example, TMA (Tri Methyl Aluminum), TEA (Tri Ethyl Aluminum) or the like is used. As the N source gas, for example, NH₃ (ammonia) is used. The AlN buffer layer 3 has a thickness of, for example, 100 nanometers or more and 1000 nanometers or less.

The composite layer 4 is in contact with the AlN buffer layer 3 and is formed on the AlN buffer layer 3. The composite layer 4 comprises a plurality of Al nitride semiconductor layers and at least one GaN layer formed between the plurality of Al nitride semiconductor layers, stacked in a vertical direction (the same direction as the stacking direction of Si substrate 1, SiC layer 2 and AlN buffer layer 3, the vertical direction in Figure 1). In other words, the composite layer 4 has a structure in which an Al nitride semiconductor layer and a GaN layer are alternately laminated one or more times, and the uppermost layer and the lowermost layer of the composite layer 4 are both Al nitride semiconductor layers.

The number of layers of the Al nitride semiconductor layer forming the composite layer 4 may be two or more, and the number of GaN layers forming the composite layer 4 may be one or more. Composite layer 4 of the present embodiment includes three Al nitride semiconductor layers 41a, 41b, and 41c (an example of multiple lower nitride semiconductor layers) as Al nitride semiconductor layers, and includes two GaN layers 42a and 42b (an example of lower GaN layers) as GaN layers. Al nitride semiconductor layer 41a is formed at a position among the positions of three Al nitride semiconductor layers 41a, 41b, and 41c, which is the closest to Si substrate 1, and is in contact with AlN buffer layer 3. Al nitride semiconductor layer 41b is formed at a position among the positions of three Al nitride semiconductor layers 41a, 41b, and 41c, which is the second closest to Si substrate 1. Al nitride semiconductor layer 41c is formed at a position among the positions of three Al nitride semiconductor layers 41a, 41b, and 41c, which is farthest from Si substrate 1. The GaN layer 42a is formed between the Al nitride semiconductor layer 41a and the Al nitride semiconductor layer 41b. The GaN layer 42b is formed between the Al nitride semiconductor layer 41b and the Al nitride semiconductor layer 41c.

Each of the Al nitride semiconductor layers comprising the composite layer 4 is made of a nitride semiconductor containing Al, preferably AlN. Each of the Al nitride semiconductor layers comprising the composite layer 4 is, for example, made of a material represented by AlₓGa₁₋ₓN (0 < x ≦ 1). In this case, by setting the Al composition ratio x to 0.5 or more, the Ga composition ratio becomes 0.5 or less, and the effect of warpage control by the composite layer 4 can be increased. Each of the Al nitride semiconductor layers comprising the composite layer 4 may be made of a material represented by AlₓIn_{y}Ga_{1-x-y}N (0 < x ≦ 1, 0 ≦ y <1). The Al nitride semiconductor layer comprising composite layer 4 functions as a buffer layer that relaxes the difference in the lattice constant values between AlN buffer layer 3 and the GaN layer in composite layer 5. The total film thickness of the Al nitride semiconductor layer comprising composite layer 4 is, for example, 100 nanometers or more and 3 micrometers or less, preferably 900 nanometers or more and 2 micrometers or less.

The Al nitride semiconductor layer comprising composite layer 4 is formed by using, for example, the MOCVD method. At this time, as the Ga source gas, for example, TMG (Tri Methyl Gallium), TEG (Tri Ethyl Gallium) or like is used. As the Al source gas, for example, TMA, TEA, or the like is used. As the N source gas, for example, NH₃ or the like is used.

As described below, the GaN layer comprising the composite layer 4 plays a role of generating warpage having a concave shape on the compound semiconductor substrate CS1.

The GaN layer comprising the composite layer 4 is formed by using, for example, the MOCVD method. At this time, as the Ga source gas, TMG, TEG or the like is used, for example. As the N source gas, NH₃ or the like is used.

The GaN layer comprising the composite layer 4 has a thickness of, for example, 3 nanometers or more and 100 nanometers or less, and preferably 10 nanometers or more and 60 nanometers or less. If there are multiple GaN layers that comprise composite layer 4, the GaN layers comprising the composite layer 4 may have the same thickness or different thicknesses.

The composite layer 5 is in contact with the composite layer 4 (Al nitride semiconductor layer 41c) and is formed on the composite layer 4 (Al nitride semiconductor layer 41c). Composite layer 5 includes a plurality of GaN layers, and at least one Al nitride semiconductor layer formed between the plurality of GaN layers stacked in a vertical direction (in the direction same as the stacking direction of Si substrate 1, SiC layer 2, AlN buffer layer 3, and composite layer 4, which is the vertical direction in Figure 1). In other words, the composite layer 5 has a structure in which the GaN layer and the Al nitride semiconductor layer are alternately laminated one or more times, and both the uppermost layer and the lowermost layer of the composite layer 5 are GaN layers.

The number of the GaN layers forming the composite layer 5 may be two or more, and the number of Al nitride semiconductor layers forming the composite layer 5 may be one or more. Composite layer 5 of the present embodiment includes three layers of GaN layers 51a, 51b, and 51c (an example of a plurality of upper GaN layers) as the GaN layers, and two layers of Al nitride semiconductor layers 52a and 52b (an example of the upper nitride semiconductor layer) as the Al nitride semiconductor layer. The GaN layer 51a is formed at a position closest to the Si substrate 1 among the three layers of GaN layers 51a, 51b, and 51c, and is in contact with composite layer 4 (Al nitride semiconductor layer 41c). The GaN layer 51b is formed at the second closest position to the Si substrate 1 among the three layers of GaN layers 51a, 51b, and 51c. The GaN layer 51c is formed farthest from the Si substrate 1 among the three layers of GaN layers 51a, 51b, and 51c. The A1 nitride semiconductor layer 52a is formed between the GaN layer 51a and the GaN layer 51b. The Al nitride semiconductor layer 52b is formed between the GaN layer 51b and the GaN layer 51c.

It is preferable that each of the GaN layers forming the composite layer 5 be doped with C (carbon). C plays a role of enhancing the insulating property of the GaN layer. The C-doped GaN layer preferably has an average carbon atom concentration of 1^{∗}10¹⁸ / cm³ or more and 1^{∗}10²¹ / cm³ or less. More preferably, it has an average carbon concentration of 3^{∗}10¹⁸ / cm³ or more and 2^{∗}10¹⁹ / cm³ or less. If there are multiple C-doped GaN layers, the GaN layers may have the same average carbon atom concentration or may have different average carbon atom concentrations.

When C is doped in the GaN layer constituting the composite layer 5, the growth conditions of GaN in which the C contained in TMG is taken into the GaN layer are adopted. Specific methods for doping C in the GaN layer include a method of lowering the growth temperature of GaN, a method of lowering the growth pressure of GaN, and a method of increasing the molar flow ratio of TMG to NH₃.

Each of the GaN layers forming the composite layer 5 has a thickness of, for example, 550 nanometers or more and 3000 nanometers or less, and preferably 800 nanometers or more and 2000 nanometers or less. Each of the GaN layers forming the composite layer 5 may have the same thickness or may have different thicknesses. The GaN layer comprising the composite layer 5 is formed in the same manner as the GaN layer comprising the composite layer 4.

As described below, the Al nitride semiconductor layer comprising the composite layer 5 plays a role of generating warpage having a convex shape on the compound semiconductor substrate CS1.

The Al nitride semiconductor layer comprising composite layer 5 is made of a nitride semiconductor containing Al, preferably AlN. For example, the Al nitride semiconductor layer comprising composite layer 5 is made of a material represented by AlₓGa₁₋ₓN (0 < x ≦ 1). In this case, by setting the Al composition ratio x to 0.5 or more, the Ga composition ratio becomes 0.5 or less, and the effect of warpage control by the composite layer 4 can be increased. The Al nitride semiconductor layer comprising composite layer 5 may be made of a material represented by AlₓIn_{y}Ga_{1-x-y}N (0 < x ≦ 1, 0 ≦ y <1).

The Al nitride semiconductor layer comprising composite layer 5 has a thickness of, for example, 3 nanometers or more and 50 nanometers or less, and preferably 20 nanometers or less. If there are multiple Al nitride semiconductor layers comprising composite layer 5, each of the Al nitride semiconductor layers comprising composite layer 5 may have the same thickness or may have different thicknesses. The Al composition ratio of each of the Al nitride semiconductor layer comprising composite layer 5 is arbitrary. The Al nitride semiconductor layer comprising composite layer 5 is formed in the same manner as the Al nitride semiconductor layer comprising composite layer 4.

The GaN layer 7 is in contact with the composite layer 5 and is formed on the composite layer 5. GaN layer 7 is undoped and semi-insulating. The GaN layer 7 becomes an electron traveling layer of the HEMT. The GaN layer 7 has a thickness of, for example, 100 nanometers or more and 1500 nanometers or less. The GaN layer 7 is formed by a method similar to that of the GaN layer constituting composite layer 4.

The Al nitride semiconductor layer 10 is in contact with the GaN layer 7 and is formed on the GaN layer 7. The Al nitride semiconductor layer 10 is made of a nitride semiconductor containing Al, and made of a material represented by AlₓGa₁₋ₓN (0 < x ≦ 1), for example. The Al nitride semiconductor layer 10 may be made of a material represented by AlₓIn_{y}Ga_{1-x-y}N (0 < x ≦ 1, 0 ≦ y <1). The Al nitride semiconductor layer 10 becomes a barrier layer of the HEMT. The Al nitride semiconductor layer 10 has a thickness of, for example, 10 nanometers or more and 50 nanometers or less. The Al nitride semiconductor layer 10 is formed by a method similar to that of the GaN layer constituting composite layer 4.

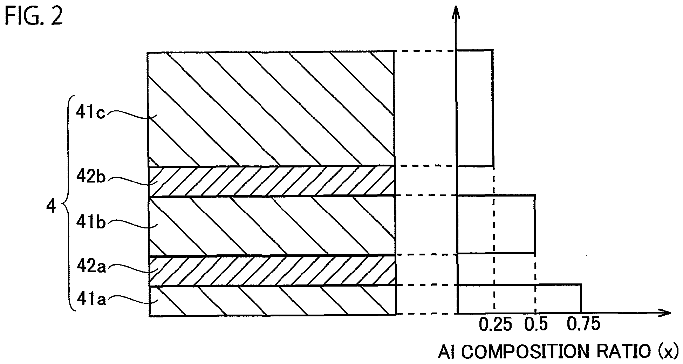

FIG. 2 is a diagram showing distribution of Al composition ratios inside composite layer 4 in the first embodiment of the present invention.

Referring to Figure 2, when comparing the average composition ratio of Al of each of the Al nitride semiconductor layers 41a, 41b, and 41c as the Al nitride semiconductor layers comprising composite layer 4, it is preferable that the average composition ratio of Al becomes smaller as the Al nitride semiconductor layer is formed at a position further away from the SiC layer 2 which is the foundation layer. In particular, the Al nitride semiconductor layer 41a closest to the SiC layer 2 is made of Al_{0.75}Ga_{0.25}N (AlGaN whose Al composition ratio is 0.75). The Al nitride semiconductor layer 41b, which is the second closest to the SiC layer 2, is made of Al_{0.5}Ga_{0.5}N (AlGaN whose Al composition ratio is 0.5). The Al nitride semiconductor layer 41c farthest from the SiC layer 2 is made of Al_{0.25}Ga_{0.75}N (AlGaN whose Al composition ratio is 0.25). The above Al composition ratio is an example, and each of the Al nitride semiconductor layers comprising the composite layer 4 may have another composition ratio. The average composition ratio of Al may change inside one Al nitride semiconductor layer. The Al composition ratio may become smaller as the distance from the Si substrate 1 inside one Al nitride semiconductor layer.

Next, the effect of this embodiment will be described.

The "convex shape" and "concave shape" in the following description mean the convex shape and the concave shape when the Si substrate 1 is on the lower side and the Al nitride semiconductor layer 10 is on the upper side.

Referring to Figure 1, attention is paid to the relationship among the GaN layer 42b, the Al nitride semiconductor layer 41b that is the foundation layer of the GaN layer 42b, and the Al nitride semiconductor layer 41c that is the upper layer of the GaN layer 42b, in composite layer 4.

The boundary face BR1 between the GaN layer 42b and the Al nitride semiconductor layer 41b is the sliding surface. In other words, At boundary face BR1, the crystal of GaN layer 42b and the crystal of Al nitride semiconductor layer 41b are unconformity. For this reason, the effect of the crystal structure of the Al nitride semiconductor layer 41b on the crystal structure of the GaN layer 42b is small, and the effect of the lattice constant value of Al nitride semiconductor layer 41b on the lattice constant value of GaN layer 42b is small.

On the other hand, the Al nitride semiconductor layer 41c grows so as to be aligned with the crystal plane of the surface of the GaN layer 42b which is the foundation layer. For this reason, the crystal structure of Al nitride semiconductor layer 41c is affected by the crystal structure of GaN layer 42b, and the lattice constant value of Al nitride semiconductor layer 41c is influenced by the lattice constant value of GaN layer 42b. Since the lattice constant value of the material forming the Al nitride semiconductor layer 41c (AlGaN, AlN, etc.) is smaller than the lattice constant value of GaN forming the GaN layer 42b, tensile stress is added to the Al nitride semiconductor layer 41c, and tensile strain is generated inside the Al nitride semiconductor layer 41c. As a reaction of the tensile stress, the composite layer 4 causes warpage of a concave shape on the compound semiconductor substrate CS1.

By controlling the conditions of epitaxial growth of GaN layer 42b (temperature, pressure, etc.), the boundary face BR1 between the GaN layer 42b and the Al nitride semiconductor layer 41b can be the sliding surface. By controlling the conditions of epitaxial growth of Al nitride semiconductor layer 41c (temperature, pressure, etc.), the Al nitride semiconductor layer 41c can be grown (coherent grown) so that slip does not occur on the crystal plane of the surface of the GaN layer 42b.

The same can be said when focusing on the relationship among the GaN layer 42a, the Al nitride semiconductor layer 41a that is the foundation layer of the GaN layer 42a, and the Al nitride semiconductor layer 41b that is the upper layer of the GaN layer 42a in composite layer 4. That is, the influence of the crystal structure of Al nitride semiconductor layer 41a on the crystal structure of GaN layer 42a is small, and the effect of the lattice constant value of Al nitride semiconductor layer 41a on the lattice constant value of GaN layer 42a is small. On the other hand, the Al nitride semiconductor layer 41b grows so as to be aligned with the crystal plane of the surface of the GaN layer 42a which is the foundation layer. Tensile stress is added to the Al nitride semiconductor layer 41b due to the influence of the GaN layer 42a, and tensile strain occurs inside the Al nitride semiconductor layer 41b.

The action of the composite layer 4, which generates concave shape warpage, becomes greater as the GaN layer comprising composite layer 4 becomes thicker. On the other hand, if the GaN layer constituting composite layer 4 is too thick, cracks easily occur inside the GaN layer. In order to effectively generate warpage of a concave shape due to the composite layer 4 while suppressing the occurrence of cracks into the GaN layer comprising composite layer 4, it is preferable that the thickness of the GaN layer per layer in the composite layer 4 is 3 nanometers or more and 100 nanometers or less, preferably 10 nanometers or more and 60 nanometers or less, and the number of GaN layers in the composite layer 4 is about 1 to 2 layers.

Next, attention is paid on the relationship among Al nitride semiconductor layer 52b in composite layer 5, GaN layer 51b which is the foundation layer of Al nitride semiconductor layer 52b, and GaN layer 51c which is the upper layer of Al nitride semiconductor layer 52b.

The boundary face BR2 between the Al nitride semiconductor layer 52b and the GaN layer 51b is a sliding surface. In other words, in the boundary face BR2, the crystal of Al nitride semiconductor layer 52b and the crystal of GaN layer 51b are unconformity. For this reason, the influence of the crystal structure of GaN layer 51b on the crystal structure of Al nitride semiconductor layer 52b is small, and the effect of the lattice constant value of GaN layer 51b on the lattice constant value of Al nitride semiconductor layer 52b is small.

On the other hand, the GaN layer 51c grows so as to be aligned with the crystal plane of the surface of the Al nitride semiconductor layer 52b which is the foundation layer. For this reason, the crystal structure of GaN layer 51c is influenced by the crystal structure of Al nitride semiconductor layer 52b, and the lattice constant value of GaN layer 51c is influenced by the lattice constant value of Al nitride semiconductor layer 52b. Since the lattice constant value of GaN that composes the GaN layer 51c is larger than the lattice constant value of the material that composes the Al nitride semiconductor layer 52b (AlGaN, AlN, etc.), compression stress is added to the GaN layer 51c, and compressive strain occurs inside the GaN layer 51c. As a reaction of the compression stress, the composite layer 5 generates convex shape warpage on the compound semiconductor substrate CS1.

By controlling the conditions of epitaxial growth of Al nitride semiconductor layer 52b (temperature, pressure, etc.), the boundary face BR2 between the Al nitride semiconductor layer 52b and the GaN layer 51b can be the sliding surface. By controlling the conditions of epitaxial growth of GaN layer 51c (temperature, pressure, etc.), the GaN layer 51c can be grown so as to be aligned with the crystal plane of the surface of the Al nitride semiconductor layer 52b.

The same can be said when paying attention to the relationship among Al nitride semiconductor layer 52a, GaN layer 51a which is the foundation layer of Al nitride semiconductor layer 52a, and GaN layer 51b which is the upper layer of Al nitride semiconductor layer 52a in composite layer 5. That is, the influence of the crystal structure of GaN layer 51a on the crystal structure of Al nitride semiconductor layer 52a is small, and the effect of the lattice constant value of GaN layer 51a on the lattice constant value of Al nitride semiconductor layer 52a is small. On the other hand, the GaN layer 51b grows so as to be aligned with the crystal plane of the surface of the Al nitride semiconductor layer 52a which is the foundation layer. Compression stress is added to the GaN layer 51b due to the influence of the Al nitride semiconductor layer 52a, and compressive strain occurs inside the GaN layer 51b.

The action of the composite layer 5 that generates convex shape warpage increases as the thickness of the Al nitride semiconductor layer comprising composite layer 5 increases. On the other hand, if the Al nitride semiconductor layer comprising composite layer 5 is too thick, cracks are likely to occur inside the Al nitride semiconductor layer. In order to prevent the occurrence of cracks into the Al nitride semiconductor layer comprising composite layer 5 and effectively generate the warpage of the convex shape by the composite layer 5, it is preferable that the thickness of the Al nitride semiconductor layer per layer in the composite layer 5 is 3 nanometers or more and 50 nanometers or less, preferably 20 nanometers or less, and the number of Al nitride semiconductor layers in the composite layer 5 is about 1 to 2 layers.

According to this embodiment, by controlling composite layer 4 that has the function to generate warpage of a concave shape on compound semiconductor substrate CS1 and composite layer 5 that has the function to generate warpage of a convex shape on compound semiconductor substrate CS1, the warpage of compound semiconductor substrate CS1 can be easily controlled.

In addition, since the semiconductor layer on boundary faces BR1 and BR2 which are sliding faces can grow without being affected by the lattice constant value differences and distortion of the foundation layer, the generation of cracks can also be suppressed.

### [Second Embodiment]

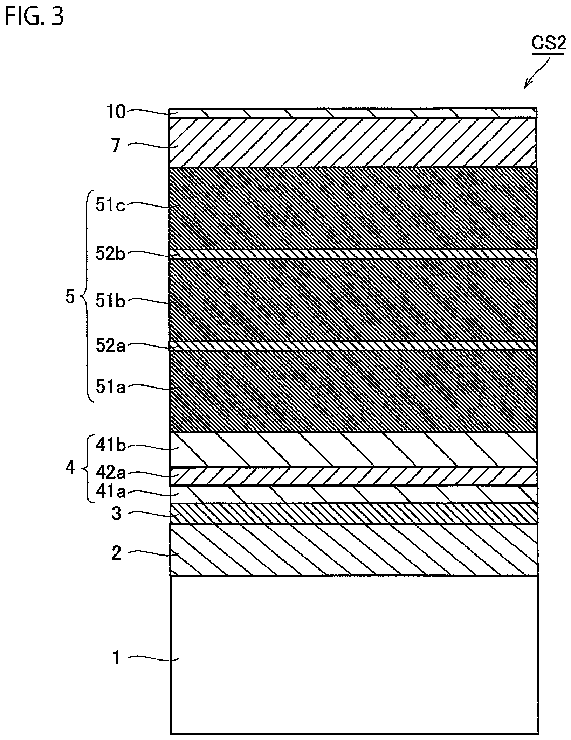

FIG. 3 is a cross-sectional view showing the structure of the compound semiconductor substrate CS2 in the second embodiment of the present invention.

Referring to FIG. 3, composite layer 4 in compound semiconductor substrate CS2 of the present embodiment includes two Al nitride semiconductor layers 41a and 41b as Al nitride semiconductor layers and one GaN layer 42a as a GaN layer. The Al nitride semiconductor layer 41a is formed at a position closer to the Si substrate 1 among two layers of Al nitride semiconductor layers 41a and 41b and is in contact with AlN buffer layer 3. The Al nitride semiconductor layer 41b is formed at a position farther from the Si substrate 1 among the two layers of Al nitride semiconductor layers 41a and 41b. The GaN layer 42a is formed between the Al nitride semiconductor layer 41a and the Al nitride semiconductor layer 41b.

Assuming that the thickness of the GaN layer constituting composite layer 4 in the present embodiment is the same as that in the first embodiment, the effect of generating warpage of a concave shape by composite layer 4 in the present embodiment is smaller than the effect of generating warpage of a concave shape by composite layer 4 of the first embodiment. For this reason, in compound semiconductor substrate CS2, the warpage amount of a convex shape can be made larger than in compound semiconductor substrate CS1. On the other hand, when the thickness of the GaN layer constituting composite layer 4 in the present embodiment is made thicker than that in the first embodiment, the compound semiconductor substrate CS2 may have the same warpage amount as the compound semiconductor substrate CS1.

Since the configurations of the compound semiconductor substrate CS2 other than the above are similar to the configurations of the compound semiconductor substrate CS1 in the first embodiment, the description will not be repeated.

According to this embodiment, it is possible to obtain the same effect as that of the first embodiment. In addition, since the number of layers of the composite layer 4 is small, the compound semiconductor substrate CS2 can be easily manufactured.

### [Examples]

The inventors of the present application conducted the following experiment in order to confirm the effect of controlling the warpage by the compound semiconductor substrate of the present invention.

Three types of compound semiconductor substrates CS1 were produced in which the thicknesses of the GaN layer 42b are 15 nanometers (sample A1), 45 nanometers (sample A2), and 60 nanometers (sample A3), respectively. In each of Samples A1, A2, and A3, the thickness of each of the Al nitride semiconductor layers 52a and 52b was set to 15 nanometers, and the thickness of the GaN layer 42a was set to 15 nanometers. Al nitride semiconductor layers 52a and 52b were made of AlN. The warpage amounts of the obtained compound semiconductor substrates CS1 were measured.

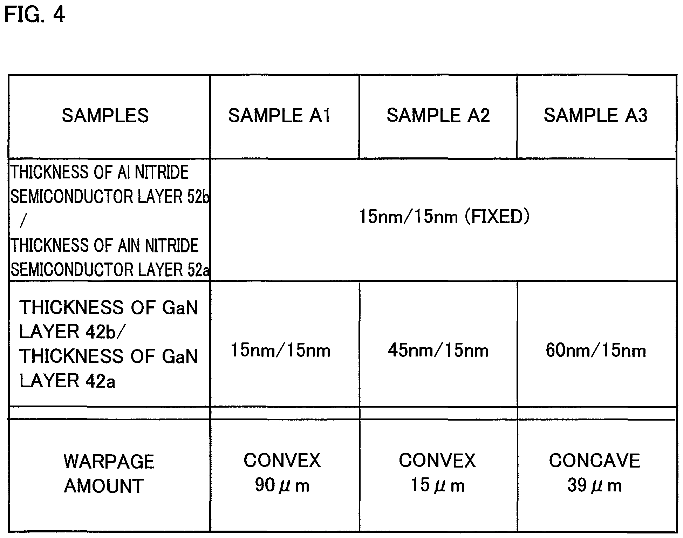

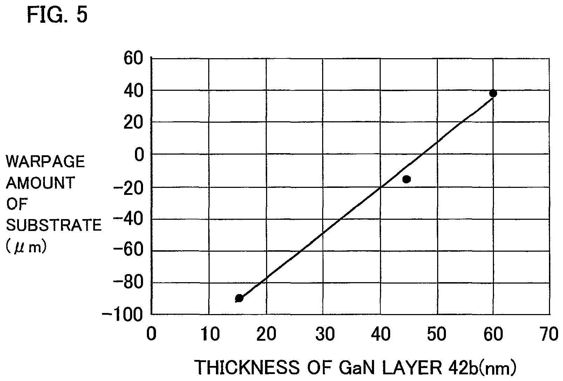

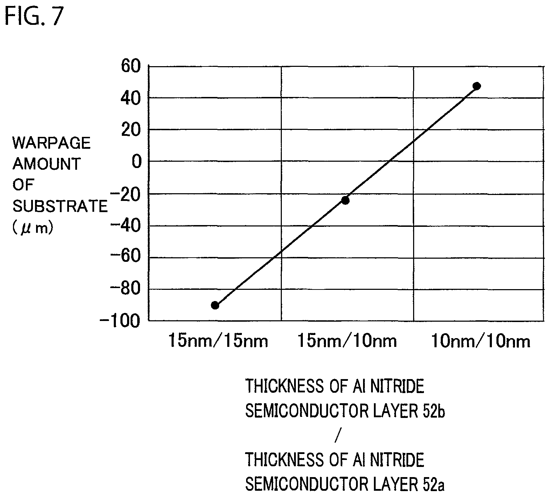

FIG. 4 is a diagram showing a measurement result of the warpage amount of each of the samples A1, A2, and A3 according to one embodiment of the present invention. FIG. 5 shows a graph indicating the relationship between the thickness of the GaN layer 42b and the warpage amount obtained from the measurement results of the warpage amount of each of samples A1, A2, and A3, according to one embodiment of the present invention. Note that, in FIGS. 5 and 7, the direction of the warpage having the convex shape is negative, and the direction of the warpage having the concave shape is positive.

Referring to FIGS. 4 and 5, the sample Al having 15 nanometers thickness GaN layer 42b has a convex shape of the warpage amount of 90 micrometers. The sample A2 having 45 nanometers thickness GaN layer 42b has a convex shape of the warpage amount of 15 micrometers. The sample A3 having 60 nanometers thickness GaN layer 42b has a concave shape of the warpage amount of 39 micrometers. As the thickness of the GaN layer 42b increased, the warpage amount of the compound semiconductor substrate CS1 increased to be a concave shape at a substantially constant rate.

Next, three types of compound semiconductor substrates CS1 were produced in which the thickness of Al nitride semiconductor layer 52b / the thickness of Al nitride semiconductor layer 52a is 15 nanometers / 15 nanometers (sample B1), 15 nanometers / 10 nanometers (sample B2), and 10 nanometers / 10 nanometers (sampleB3). In each of samples B1, B2, and B3, the GaN layers 42a and 42b each had a thickness of 15 nanometers. Al nitride semiconductor layers 52a and 52b were made of AlN. The warpage amounts of the obtained compound semiconductor substrates CS1 were measured.

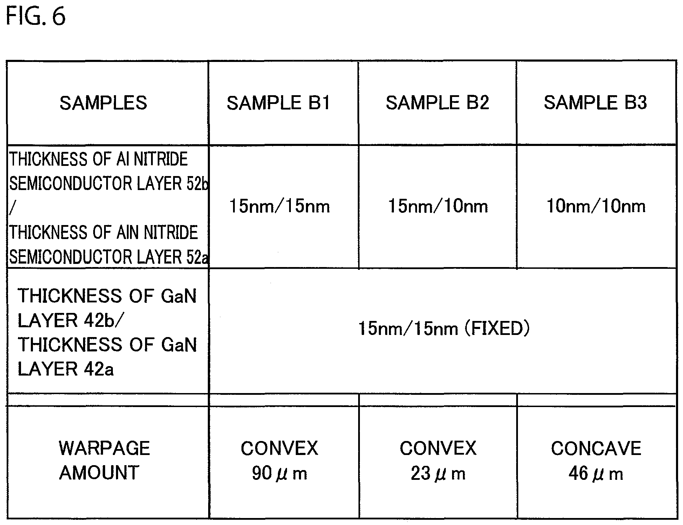

FIG. 6 is a diagram showing the measurement result of the warpage amount of each of samples B1, B2, and B3, according to one embodiment of the present invention. FIG. 7 is showing a graph indicating the relationship between the thickness of Al nitride semiconductor layers 52a and 52b and the warpage amount obtained from the measurement results of the warpage amount of each of samples B1, B2, and B3, according to one embodiment of the present invention.

Referring to FIGS. 6 and 7, sample B1 in which the thickness of Al nitride semiconductor layer 52b / the thickness of Al nitride semiconductor layer 52a is 15 nanometers / 15 nanometers has a convex shape and the warpage amount is 90 micrometers. The sample B2 in which the thickness of Al nitride semiconductor layer 52b / the thickness of Al nitride semiconductor layer 52a is 15 nanometers / 10 nanometers has a convex shape and the warpage amount is 23 micrometers. The sample B3 in which the thickness of Al nitride semiconductor layer 52b / the thickness of Al nitride semiconductor layer 52a is 10 nanometers / 10 nanometers has a concave shape and the warpage amount is 46 micrometers. As the sum total value of the thickness of Al nitride semiconductor layer 52b and the thickness of Al nitride semiconductor layer 52b decreases, the warpage amount of compound semiconductor substrate CS1 increased to a concave shape at an almost constant rate.

From the above experimental results, by adjusting the thickness of the GaN layer constituting composite layer 4 or the thickness of the Al nitride semiconductor layer comprising composite layer 5, it was found that the warpage of compound semiconductor substrate CS1 can be controlled easily.

### [Others]

The above-described embodiments and examples can be combined as appropriate.

The embodiments and examples described above are to be considered as illustrative in all points and not restrictive. The scope of the present invention is shown not by the above description but by the scope of the claims and is intended to include meanings equivalent to the scope of the claims and all modifications within the scope.

### [Explanation of reference numbers]

1 Si (silicon) substrate
2 SiC (silicon carbide) layer (an example of a foundation layer)
3 AlN (aluminum nitride) buffer layer (an example of a buffer layer)
4 composite layer (an example of a lower composite layer)
5 composite layer (an example of an upper composite layer)
7, 42a, 42b, 51a, 51b, 51c GaN (gallium nitride) layer (an example of a lower GaN layer, an example of an upper GaN layer, an example of an electrons traveling layer)
10, 41a, 41b, 41c, 52a, 52b Al (aluminum) nitride semiconductor layer (an example of a lower nitride semiconductor layer, an example of an upper nitride semiconductor layer, an example of a barrier layer)
BR1, BR2 boundary face
CS1, CS2 compound semiconductor substrate

## Claims

1. A compound semiconductor substrate comprising
a foundation layer,
a buffer layer made of AlN formed on the foundation layer,
a lower composite layer formed on the buffer layer, and
an upper composite layer formed on the lower composite layer, wherein
the lower composite layer includes
a plurality of lower nitride semiconductor layers containing Al stacked vertically, and
a lower GaN layer formed between the plurality of lower nitride semiconductor layers, and
the upper composite layer includes
a plurality of upper GaN layers stacked vertically, and
an upper nitride semiconductor layer including Al formed between the plurality of upper GaN layers.

2. The compound semiconductor substrate according to claim 1, wherein
the foundation layer is made of SiC.

3. The compound semiconductor substrate according to claim 1, wherein
the lower GaN layer has a thickness of 3 nanometers or more and 100 nanometers or less.

4. The compound semiconductor substrate according to claim 1, wherein
the upper nitride semiconductor layer has a thickness of 3 nanometers or more and 50 nanometers or less.

5. The compound semiconductor substrate according to claim 1, wherein
the plurality of lower nitride semiconductor layers are three layers, and
the lower GaN layer has two layers.

6. The compound semiconductor substrate according to claim 1, wherein
the plurality of lower nitride semiconductor layers include Al and Ga, and
the lower nitride semiconductor layer formed at a position farther from the foundation layer has smaller average composition ratio of Al, when comparing the average composition ratio of Al of each of the plurality of lower nitride semiconductor layers.

7. The compound semiconductor substrate according to claim 1, wherein
the plurality of upper GaN layers are three layers, and
the upper nitride semiconductor layer has two layers.

8. The compound semiconductor substrate according to claim 1, wherein
a lower nitride semiconductor layer formed on the lower GaN layer and in contact with the lower GaN layer among the plurality of lower nitride semiconductor layers includes tensile strain, and
an upper GaN layer formed on the upper nitride semiconductor layer and in contact with the upper nitride semiconductor layer among the plurality of upper GaN layers includes compressive strain.

9. The compound semiconductor substrate according to claim 1, wherein
the upper nitride semiconductor layer is made of AlN.

10. The compound semiconductor substrate according to claim 1, further comprising
an electron traveling layer made of GaN formed on the upper composite layer, and
a barrier layer formed on the electrons traveling layer.

11. The compound semiconductor substrate according to claim 1, wherein
each of the plurality of upper GaN layers has an average carbon atom concentration of 1 ^{∗} 10¹⁸ atoms / cm³ or more and 1 ^{∗} 10²¹ atoms / cm³ or less.

12. The compound semiconductor substrate according to claim 1, wherein
each of the plurality of upper GaN layers has a thickness of 550 nanometers or more and 3000 nanometers or less.
